# EUROPÄISCHE PATENTANMELDUNG

(11) **EP 0 951 119 A1**
(43) Veröffentlichungstag der Anmeldung: **20.10.1999**
(21) Anmeldenummer: 99103829.0
(22) Anmeldetag: 27.02.1999
(51) Int. Cl.: H02B 1/40, H02B 1/46

(54) **Rechteckiges Gehäuse zur Aufnahme elektrischer oder elektronischer Bauteile**

(30) Priorität: 17.04.1998 DE 29806875 U
(71) Anmelder: H.-J. Bernstein GmbH, 32479 Hille (DE)
(72) Erfinder: Weiss, Jürgen, 32312 Lübbecke (DE)
(74) Vertreter: Stracke, Alexander, Dipl.-Ing.

(57) **Zusammenfassung**

Beschrieben wird ein rechteckiges Gehäuse (1) zur Aufnahme elektrischer oder elektronischer Bauteile. Das Gehäuse (1) umfaßt einen die Seitenwände bildenden Rahmen (2), eine Rückwand (11) und eine vorzugsweise als anscharnierte Tür ausgebildete Vorderwand (12), wobei zumindest der Rahmen (2) aus Blech hergestellt ist.
Eine der Seitenwände ist mit einer Durchbrechung (4) sowie mit mehreren, konzentrisch zur Durchbrechung (4) angeordneten Durchgangslöchern (5, 6) versehen. Zwei der Durchgangslöcher (5, 6) weisen eine Schlüssellochform auf.
Diese Konstruktion bringt den Vorteil mit sich, daß die Montage des Gehäuses (1) an einer Tragvorrichtung vereinfacht wird. Zwei Befestigungsschrauben können provisorisch in die Tragvorrichtung eingeschraubt werden. Anschließend kann das Gehäuse aufgrund der Schlüssellochform zweier Durchgangslöcher auf die provisorisch vormontierten Befestigungsschrauben aufgeschoben und durch geringfügiges Verschieben quer zur Schraubenlängsachse vorläufig gesichert werden. Danach kann ein Monteur die weiteren Befestigungsschrauben ansetzen und festziehen, ohne dabei das Gehäuse (1) festhalten zu müssen.

## Beschreibung

Die vorliegende Erfindung betrifft ein rechteckiges Gehäuse zur Aufnahme elektrischer oder elektronischer Bauteile, umfassend einen die Seitenwände bildenden Rahmen, eine Rückwand und eine vorzugsweise als anscharnierte Tür ausgebildete Vorderwand, wobei zumindest der Rahmen aus Blech hergestellt ist und eine der Seitenwände mit einer Durchbrechung sowie mit mehreren, konzentrisch zur Durchbrechung angeordneten Durchgangslöchern versehen ist.

Gehäuse der gattungsgemäßen Art werden üblicherweise an zumeist schwenkbaren Trageinrichtungen befestigt. Die Festlegung erfolgt dabei über Befestigungsschrauben, welche die Durchgangslöcher in der betreffenden Seitenwand des Gehäuses durchtreten und in Gewindebohrungen einer Haltevorrichtung eingeschraubt werden. Die Durchbrechung der betreffenden Seitenwand dient dazu, innerhalb der Trageinrichtung verlegte Stromkabel in das Gehäuseinnere führen zu können.

Bei den bislang bekannten Gehäusen sind die Durchgangslöcher kreisrund ausgeführt und im Durchmesser so gewählt, daß die Befestigungsschrauben behinderungsfrei durch diese Durchgangslöcher hindurchgeführt werden können.

Bei der Montage eines Gehäuses ist es demzufolge bislang erforderlich, das Gehäuse zunächst von Hand in die gewünschte Montageposition zu bringen und dort von Hand solange festzuhalten, bis zumindest zwei Befestigungsschrauben provisorisch angezogen sind.

Aufgrund des Gewichtes der entsprechenden Gehäuse mit den darin angeordneten elektrischen oder elektronischen Bauteilen ist die Montage bzw. die Festlegung eines derartigen Gehäuses an einer Tragvorrichtung bislang von einer Person nicht durchzuführen, da es nicht möglich ist, ein solches Gehäuse mit einer Hand in Montageposition zu halten und um dann mit der anderen Hand Befestigungsschrauben eindrehen zu können.

Der vorliegenden Erfindung liegt die Aufgabe zugrunde, ein Gehäuse der gattungsgemäßen Art so zu gestalten, daß die Verbindung des Gehäuses mit einer Tragvorrichtung montagetechnisch vereinfacht wird dahingehend, daß die Montage von nur einer Person durchführbar ist.

Diese Aufgabe wird erfindungsgemäß dadurch gelöst, daß zumindest zwei der Durchgangslöcher eine Schlüssellochform aufweisen.

Diese vergleichsweise einfache Maßnahme bringt den Vorteil mit sich, daß die Montage eines derartigen Gehäuses an einer Tragvorrichtung erheblich vereinfacht wird. Zunächst können zwei Befestigungsschrauben provisorisch in die Tragvorrichtung eingeschraubt werden. Anschließend kann das Gehäuse aufgrund der Schlüssellochform zweier Durchgangslöcher über die Schraubenköpfe der provisorisch vormontierten Befestigungsschrauben aufgeschoben und durch geringfügiges Verschieben quer zur Schraubenlängsachse vorläufig gesichert werden. Anschließend kann der Monteur die weiteren Befestigungsschrauben ansetzen und festziehen, ohne daß es notwendig ist, während dieser Arbeiten das Gehäuse festzuhalten, da dieses schon durch die provisorisch eingedrehten Befestigungsschrauben gesichert ist.

Weitere Merkmale der Erfindung sind Gegenstand von Unteransprüchen.

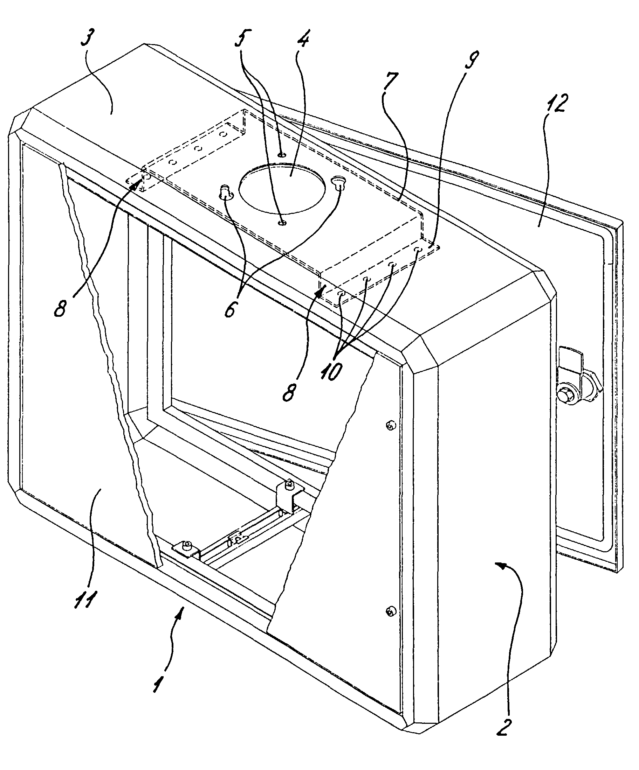

Ein bevorzugtes Ausführungsbeispiel der Erfindung ist in der beigefügten Zeichnung dargestellt und wird im folgenden näher beschrieben.

Die einzige Figur zeigt eine perspektivische Darstellung eines erfindungsgemäßen Gehäuses.

Das insgesamt mit dem Bezugszeichen 1 versehene, rechteckige Gehäuse weist einen aus Blech gefertigten, die Seitenwände bildenden Rahmen 2 auf, wobei eine mit dem Bezugszeichen 3 versehene Seitenwand mit einer Durchbrechung 4 sowie mehreren, konzentrisch zu dieser Durchbrechung 4 angeordneten Durchgangslöchern 5 bzw. 6 versehen ist.

Die beiden mit dem Bezugszeichen 6 versehenen Durchgangslöcher weisen eine Schlüssellochform auf, während die beiden anderen Durchgangslöcher 5 eine kreisrunde Form aufweisen.

Der erweiterte Durchgangsbereich der schlüssellochförmigen Durchgangslöcher 6 ist größer gewählt als der Kopf einer Befestigungsschraube zum Festlegen des Gehäuses 1 an einer nicht dargestellten Tragvorrichtung, während der schmalere Bereich der schlüssellochförmigen Durchgangslöcher 6 praktisch dem Durchmesser der kreisförmigen Durchgangslöcher 5 entspricht.

Werden in eine Tragvorrichtung zwei Befestigungsschrauben provisorisch eingeschraubt, so kann das Gehäuse 1 über die beiden schlüssellochartigen Durchgangslöcher 6 in eine Vormontagestellung gebracht und gesichert werden, anschließend werden die noch fehlenden Befestigungsschrauben angesetzt und die Befestigungsschrauben insgesamt festgezogen. Diese vereinfachte Montage ist von einer Person alleine durchführbar, da es keine Notwendigkeit mehr gibt, das Gehäuse 1 festzuhalten und gleichzeitig Befestigungsschrauben einzuschrauben.

Die mit der Durchbrechung 4 und den Durchgangslöchern 5 und 6 versehene Seitenwand 3 ist in dem vorstehend genannten Bereich mit einer Verstärkungsplatte 7 versehen, die an der Gehäuseinnenseite der betreffenden Seitenwand 3 festgelegt ist. Diese Verstärkungsplatte 7 versteift und verstärkt die Seitenwand 3 im Verbindungsbereich zu einer Tragvorrichtung.

Vorteilhafterweise ist die Verstärkungsplatte 7 an zwei gegenüberliegenden Stirnkanten mit L-förmigen Abkantungen 8 versehen, wobei der jeweils untere Schenkel 9 dieser Abkantungen 8 mit mehreren Bohrungen 10 ausgestattet ist.

Diese Bohrungen 10 können zur geordneten Verlegung von Stromkabeln im Inneren des Gehäuses 1 genutzt werden.

Das Gehäuse 1 kann in an sich bekannter Weise durch eine Rückwand 11 sowie eine Tür 12 verschlossen werden. Die Tür 12 kann gegebenenfalls auch durch eine einfache Vorderwand ersetzt werden, die nur mit dem Gehäuse 1 im übrigen verschraubt ist.

## Patentansprüche

1. Rechteckiges Gehäuse zur Aufnahme elektrischer oder elektronischer Bauteile, umfassend einen die Seitenwände bildenden Rahmen, eine Rückwand und eine vorzugsweise als anscharnierte Tür ausgebildete Vorderwand, wobei zumindest der Rahmen aus Blech hergestellt ist und eine der Seitenwände mit einer Durchbrechung sowie mit mehreren, konzentrisch zu der Durchbrechung angeordneten Durchgangslöchern versehen ist, **dadurch gekennzeichnet, daß** zumindest zwei der Durchgangslöcher (6) eine Schlüssellochform aufweisen.

2. Gehäuse nach Anspruch 1, **dadurch gekennzeichnet, daß** an der mit der Durchbrechung (4) und den Durchgangslöchern (5, 6) versehenen Seitenwand (3) im Bereich der Durchbrechung (4) und der Durchgangslöcher (5, 6) auf der Gehäuseinnenseite eine Verstärkungsplatte (7) befestigt ist.

3. Gehäuse nach Anspruch 2, **dadurch gekennzeichnet, daß** die Verstärkungsplatte (7) an mindestens einer ihrer Stirnkanten mit einer L-förmigen Abkantung (8) versehen ist, wobei der untere Schenkel (9) dieser Abkantung (8) mehrere Durchgangsbohrungen (10) aufweist.
